# EUROPEAN PATENT SPECIFICATION

(11) **EP 2 200 408 B1**
(45) Date of publication and mention of the grant of the patent: **08.05.2013**
(21) Application number: 08021898.5
(22) Date of filing: 17.12.2008
(51) Int. Cl.: H05K 1/02, H05K 3/22

(54) **Circuit board device, in particular for an electric power consuming device in a motor vehicle**
Platinenvorrichtung, insbesondere für eine stromverbrauchende Vorrichtung in einem Kraftfahrzeug
Dispositif de carte de circuit en particulier pour un dispositif de consommation de courant électrique dans un véhicule à moteur

(43) Date of publication of application: 23.06.2010
(73) Proprietor: Autoliv Development AB, 447 83 Vårgårda (SE)
(72) Inventor: Darraba, Roger, 78360 Montesson (FR)
(74) Representative: Müller Verweyen

(56) References cited:
- EP-A- 1 117 282
- WO-A-2007/087982
- DE-A1- 19 753 125
- JP-A- 8 274 421

## Description

The invention relates to a circuit board device for an electric motor in a reversible seatbelt pretensioner of a motor vehicle.

For printed circuit boards using Surface Mount Device (SMD) technology, different solutions for dissipating heat from power consuming integrated devices are known. Metal core PC boards can be used which contain an inner core of aluminium or copper, for instance, through which the heat losses are distributed and can be dissipated. Furthermore, it is known to provide heat sinks adhesively fastened on the component or soldered onto a copper connection surface under or next to the component. However, metal core PC boards and heat sinks lead to an increase of manufacturing costs.

It is furthermore known to provide large-dimensioned, plate-shaped copper conductors on the surface of the circuit board for conducting high currents and simultaneously dissipating heat generated in high-power ICs mounted on the circuit board. The high-current copper conductors must have a large width, enlarging the overall area of the circuit board, and must have a much higher, non-standard thickness as compared to the standard thickness of the electrical conductive pattern, which requires a high-cost multilayer manufacturing technique.

JP 08 274421 A discloses an electronic circuit board with bus bars connected to an electronic circuit on the board. A terminal of a heat generating electronic device such as a power transistor is connected to a bus bar and heat generated in the electronic device is dissipated by the bus bars.

EP 1 117 282 A1 and WO 2007 087982 A1 disclose further related electronic circuit board devices.

The object of the invention is to provide a circuit board device with simple and cost-effective means for effectively dissipating thermal energy from power components mounted on the circuit board.

The invention solves this object by the features of claim 1. The bridging bar arrangement according to the invention has several advantages. First, it can easily be dimensioned to conduct relatively large currents, for example 1 A or more. Second, because the middle portion of the bar is spaced from the surface of said circuit board, the bar surface facing the circuit board in the middle portion is exposed to the surrounding air. The bar surface exposed to the surrounding air is almost doubled in this way, which contributes to effective heat dissipation. Consequently, the bridging bar according to the invention can be made significantly smaller than the conventional plate-shaped copper conductors on the surface of the circuit board while achieving the same or an even better heat dissipation. Furthermore, in the middle section of the bar, conductors can pass under the bar such that the area under the bar can be used for the printed conductive pattern and the overall size of the circuit board can be reduced.

The bridging bars according to the invention are essentially rigid or form-stable which distinguishes them invention from a connection of two points on the circuit board by an external wire. Due to their rigidity the bridging bars can preferably be essentially free of any electrical isolation against the surrounding environment which contributes to effective heat dissipation, whereas an external wire usually must have an outer electric isolation which necessarily affects heat dissipation.

In view of effective heat dissipation the surface of a bridging bar exposed to the surrounding air is preferably large. In this respect the perimeter of the bridging bar, as viewed in a cross-section, is preferably at least 20%, more preferably at least 30%, still more preferably at least 40% larger than the perimeter of a corresponding circle. Corresponding circle is a circle which has the same cross-sectional area as the bridging bar. In this respect the maximum diameter of the bridging bar, as viewed in a cross-section, being preferably at least 5 mm, is preferably at least three times, more preferably at least five times larger than the corresponding minimum diameter, being preferably equal to or less than 1 mm.

In the following the invention shall be illustrated on the basis of preferred embodiments with reference to the accompanying drawings, wherein:
- Fig. 1: shows a perspective view onto a circuit board device;
- Fig. 2: shows a top view of the circuit board device of Fig. 1;
- Fig. 3: shows a side view of the circuit board device of Fig. 1;
- Fig. 4: shows a perspective view onto a circuit board device in another embodiment; and
- Fig. 5: a schematic view of a cross section through a bridging bar.

The circuit board device 10 comprises a circuit board 11 with a substrate 18 and a printed conductor pattern 17, and a plurality of electronic components 12 to 16 mounted on the circuit board 11 using Surface Mount Device (SMD) technology and electrically connected via the conductor pattern 17. The circuit board device 10 furthermore comprises a high current path arrangement 30 for supplying currents from an external power source not shown in the figures to an external electric power consuming device not shown in the figures as well. The electric power consuming device may be an electric motor, in particular in a safety system of a motor vehicle. A typical application is an electric motor in a reversible seatbelt pre-tensioner.

The electric power consuming device may require relatively high electric currents, i.e. higher than currents usually involved with digital signals, for example more than 1 A or even more than 5 A.

The circuit board 11 comprises a plurality of terminal sections 21, 22, 25, 26 for connecting the electric power consuming device and the external power source to the high current path arrangement 30. The terminal sections 21, 22 may be provided with pin shaped electric connectors 23, 24. For example the two terminals of a DC motor may be connectable to the connectors 23, 24 and the two terminals of a DC power source may be connectable to the terminal sections 25, 26.

The high current path arrangement 30 comprises a power control arrangement 14-16 adapted to perform power control for an electric power consuming device connected to the circuit board 11. The power control arrangement 14-16 preferably comprises one or more power integrated circuits (IC) 15, 16 which may for example be controlled by a digital microcontroller 14. Each power IC 15, 16 is connected to a corresponding terminal arrangement 21, 22 by a corresponding high current path 19, 20.

The high current path arrangement 30 furthermore comprises at least one bridging bar 27, 28. Preferably a bridging bar 27, 28 is provided for each power IC 15, 16 or more generally for each high power component. In the embodiments shown in the figures the bridging bar 27 is connected between the terminal arrangement 21 and the power IC 15, whereas the bridging by 28 is connected between the terminal arrangement 22 and the power IC 16, thus establishing high current paths 19, 20 between the terminal arrangements 21, 22 and the power ICs 15, 16.

The bridging bars 27, 28 are preferably made of tinned copper, and do not comprise any electrical isolation against the surrounding air and the circuit board 11 in order not to affect heat dissipation away from the bridging bars 27, 28. Expediently the bridging bars 27, 28 are sufficiently dimensioned to allow conduction of relatively large currents, in particular 1 A and more.

Each bridging bar 27, 28 has a first end section 31, 32 which is plate shaped and conductively connected to a conducting strip 33, 34 being part of the conductive pattern 17, and a second end section 35, 36 which is also plate shaped and conductively connected to a conducting strip 37, 38 being part of the conductive pattern 17. The end sections 31, 32, 35, 36 and the corresponding conductive strips 33, 34, 37, 38 are in planar contact in order to ensure high electrical and thermal conduction. The conducting strips 33, 34 electrically connect the terminal arrangements 21, 22 with the bridging bars 27, 28. The conducting strips 37, 38 electrically connect the bridging bars 27, 28 with the power ICs 15, 16.

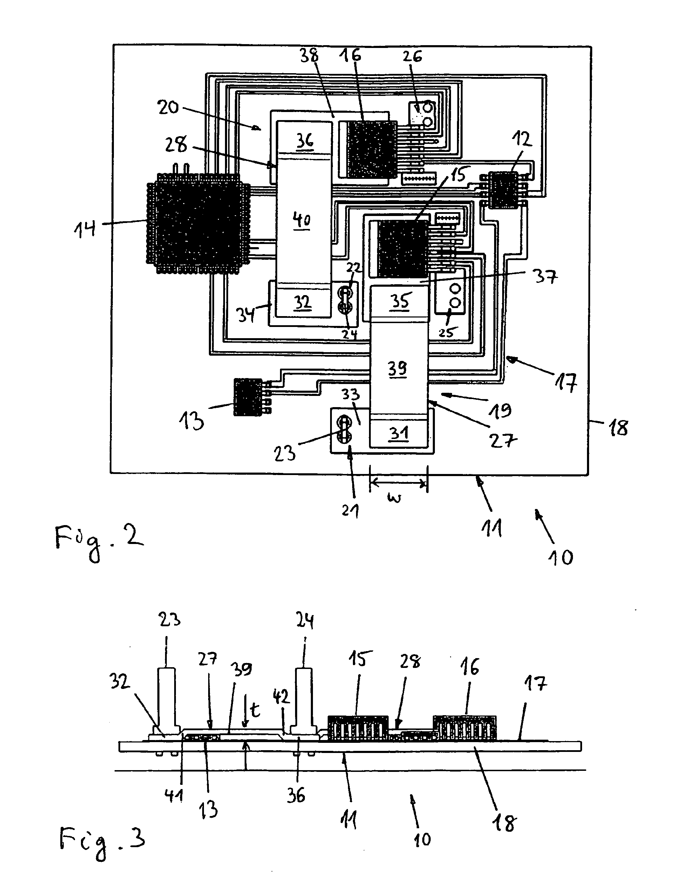

Between the first and second end sections 31, 35 and 32, 36, respectively, each bridging bar 27, 28 comprises a plate shaped middle section 39, 40 which is spaced from the circuit board 11 by means of corresponding step sections 41 to 44. Therefore, heat from the power ICs 15, 16 can be dissipated away not only from the top surface but also from the bottom surface of the middle section 39, 40 to the surrounding air. The distance between the middle section 39, 40 and the circuit board 11 may preferably be approximately equal to or larger than the thickness t (see Fig. 3) of the bridging bar 27, 28. As shown in the figures the bridging bars 27, 28 are arranged as close as possible to the corresponding power ICs 15, 16 in order to provide optimal cooling of the power ICs 15, 16 by using the bridging bars 27, 28 as heat sinks.

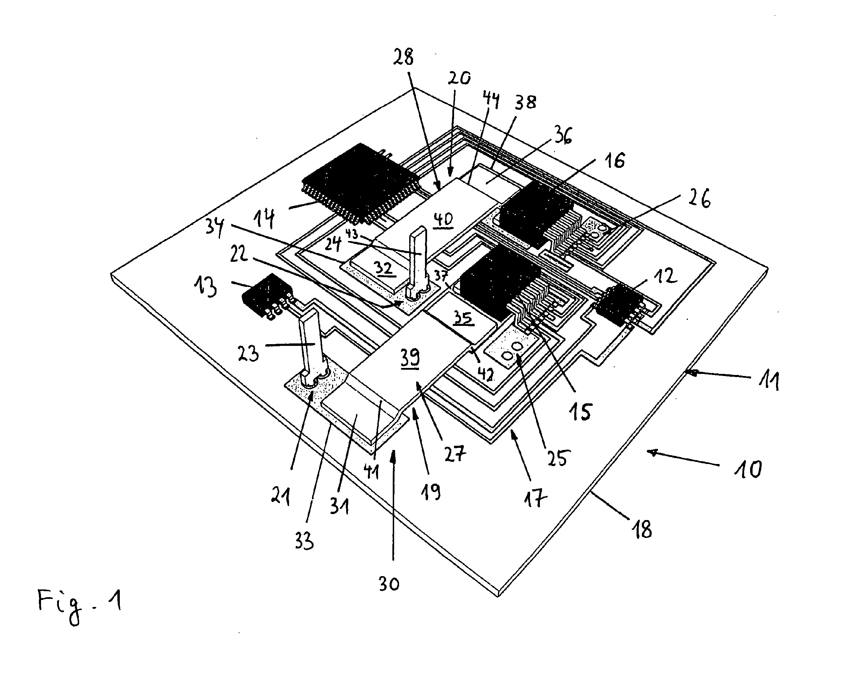

As is evident from figures 1 and 2 conductors of the conductive pattern 17 can be arranged running through under the middle section 39, 40 of the bridging bars 27, 28 contributing to an effective use of the board area and therefore to a reduced board size.

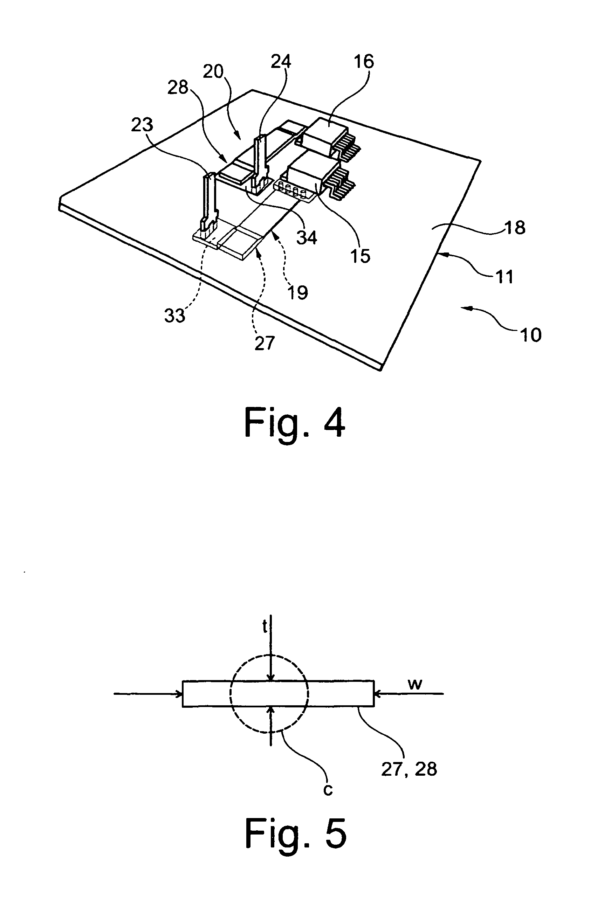

The width w of the bridging bars 27, 28, more generally the maximum diameter in cross section, is preferably at least three times larger, more preferably at least five times larger than the thickness t of the bridging bars 27, 28, more generally the minimum diameter in cross section. In general, in a cross-section through each of the bridging bars 27, 28 (see figure 5) the perimeter of the bridging bar 27, 28 is preferably at least 20% larger, more preferably at least 30% larger, still more preferably at least 40% larger than the perimeter of a corresponding circle C which has the same area as the bridging bar 27, 28 in cross-section. This means that the heat dissipation from the bridging bar is higher by the same amount in comparison to a corresponding circular wire, i.e. a circular wire using the same amount of material per unit length as the bridging bar. Preferably the width w of the bridging bars 27, 28 is at least 5 mm, preferably approximately 10 mm. Preferably the thickness of the bridging bars 27, 28 is equal to or less than 1 mm, for example approximately 0.5 mm.

In the case of a preferred rectangular cross-section of the bridging bar with width w and thickness t this leads to the following values: perimeter of bridging bar in cross-section = 2(w+t); perimeter of corresponding circle = 2√(πwt); ratio of perimeter of bridging bar in cross-section to perimeter of corresponding circle = (1+s)/√(πs) with s=w/t. For example if the width w is three times (five times) larger than the thickness t, the perimeter of the bridging bar is more than 30% (50%) larger than the perimeter of the corresponding circle.

The embodiment shown in figure 4 differs from the one of figures 1 to 3 in that the bridging bar 27 is arranged on the opposite side of the circuit board 11 than the bridging bar 28. This has the advantage that heat can be dissipated from both sides away from the circuit board 11, which contributes to effective cooling.

## Claims

1. A circuit board device (10) for an electric motor in a reversible seatbelt pretensioner of a motor vehicle, comprising a circuit board (11) with a substrate (18) and at least one layer (17) of electrically conductive pattern, and at least one electronic component (12-16) mounted on said circuit board (11) and electrically connected via said electrically conductive pattern (17), wherein said circuit board device (10) comprises a plurality of electrically conducting bridging bars (27, 28) each connected to the surface of said circuit board (11) with end sections (31, 32, 35, 36) and spaced from the surface of said circuit board (11) in a middle section (39, 40), wherein said bridging bars (27, 28) are arranged on opposite sides of the circuit board, wherein said bridging bars (27, 28) are essentially plate-shaped and essentially free of electrical isolation against the surrounding air, and wherein said bridging bars (27, 28) are made of metal, in particular copper, and are metal-coated, in particular tinned.

2. The device according to claim 1, wherein in a cross-section through a said bridging bar (27, 28) the perimeter of said bridging bar (27, 28) is at least 20%, preferably at least 30%, more preferably at least 40% larger than the perimeter of a circle (C) having the same area as said cross-section through said bridging bar (27, 28).

3. The device according to any one of the preceding claims, wherein in a cross-section through a said bridging bar (27, 28) the maximum diameter (w) is at least three times larger, preferably at least five times larger than the minimum diameter (t).

4. The device according to any one of the preceding claims, wherein in a cross-section through a said bridging bar (27, 28) the maximum diameter (w) is at least 5 mm, preferably approximately 10 mm.

5. The device according to any one of the preceding claims, wherein in a cross-section through a said bridging bar (27, 28) the minimum diameter (t) is equal to or less than 1 mm, preferably approximately 0.5 mm.

6. The device according to any one of the preceding claims, wherein said bridging bars (27, 28) are part of a high current path (19, 20) on said circuit board (11).

7. The device according to claim 6, wherein said high current path (19, 20) is connectable to an external electric motor.

8. The device according to claim 6 or 7, wherein said high current path (19, 20) is connectable to an external power supply for said electric power consuming device.

9. The device according to any one of the preceding claims, wherein a said bridging bar (27, 28) is dimensioned to conduct currents of at least 1 A.

## Patentansprüche

1. Platinenvorrichtung (10) für einen Elektromotor in einem reversiblen Gurtstraffer eines Kraftfahrzeugs, umfassend eine Platine (11) mit einem Träger (18) und mindestens einer Leiterbahnraster-Schicht (17), sowie mindestens ein elektronisches Bauteil (12-16), das auf der Platine (11) montiert und über das Leiterbahnraster (17) elektrisch angeschlossen ist, wobei die Platinenvorrichtung (10) eine Vielzahl elektrisch leitender Überbrückungsschienen (27, 28) umfasst, die jeweils mit der Oberfläche der Platine (11) mit Endabschnitten (31, 32, 35, 36) verbunden sind und zu der Oberfläche der Platine (11) in einem mittleren Abschnitt (39, 40) einen Abstand aufweisen, wobei die Überbrückungsschienen (27, 28) auf gegenüberliegenden Seiten der Platine angeordnet sind, wobei die Überbrückungsschienen (27, 28) im Wesentlichen plattenförmig sind und im Wesentlichen keine elektrische Isolierung gegenüber der Umgebungsluft aufweisen, und wobei die Überbrückungsschienen (27, 28) aus Metall hergestellt sind, insbesondere Kupfer, und mit Metall beschichtet, insbesondere verzinnt, sind.

2. Vorrichtung nach Anspruch 1, wobei in einem Querschnitt durch eine solche Überbrückungsschiene (27, 28) der Umfang der Überbrückungsschiene (27, 28) mindestens 20 %, vorzugsweise mindestens 30 %, bevorzugter mindestens 40 % größer als der Umfang eines Kreises (C) ist, der denselben Flächeninhalt wie der Querschnitt durch die Überbrückungsschiene (27, 28) aufweist.

3. Vorrichtung nach einem der vorhergehenden Ansprüche, wobei in einem Querschnitt durch eine solche Überbrückungsschiene (27, 28) der Höchstdurchmesser (w) mindestens dreimal größer, vorzugsweise mindestens fünfmal größer als der Mindestdurchmesser (t) ist.

4. Vorrichtung nach einem der vorhergehenden Ansprüche, wobei in einem Querschnitt durch eine solche Überbrückungsschiene (27, 28) der Höchstdurchmesser (w) mindestens 5 mm, vorzugsweise ungefähr 10 mm beträgt.

5. Vorrichtung nach einem der vorhergehenden Ansprüche, wobei in einem Querschnitt durch eine solchen Überbrückungsschiene (27, 28) der Mindestdurchmesser (t) gleich oder kleiner 1 mm, vorzugsweise ungefähr 0,5 mm beträgt.

6. Vorrichtung nach einem der vorhergehenden Ansprüche, wobei die Überbrückungsschienen (27, 28) Teil einer Hochstromstrecke (19, 20) auf der Platine (11) sind.

7. Vorrichtung nach Anspruch 6, wobei die Hochstromstrecke (19, 20) mit einem externen Elektromotor verbindbar ist.

8. Vorrichtung nach Anspruch 6 oder 7, wobei die Hochstromstrecke (19, 20) mit einer externen Stromversorgung für die stromverbrauchende Vorrichtung verbindbar ist.

9. Vorrichtung nach einem der vorhergehenden Ansprüche, wobei eine solche Überbrückungsschiene (27, 28) so bemessen ist, dass sie Ströme von mindestens 1 A leitet.

## Revendications

1. Dispositif de carte de circuit (10) pour un moteur électrique dans un prétendeur de ceinture de sécurité réversible d'un véhicule à moteur, comprenant une carte de circuit (11) avec un substrat (18) et au moins une couche (17) d'impression électriquement conductrice, et au moins un composant électronique (12-16) monté sur ladite carte de circuit (11) et connecté électriquement via ladite impression électriquement conductrice (17), dans lequel ledit dispositif de carte de circuit (10) comprend une pluralité de barres de pontage électriquement conductrices (27, 28) chacune connectée à la surface de ladite carte de circuit (11) avec des sections d'extrémité (31, 32, 35, 36) et espacées de la surface de ladite carte de circuit (11) dans une section centrale (39, 40), dans lequel lesdites barres de pontage (27, 28) sont agencées sur des côtés opposés de la carte de circuit, dans lequel lesdites barres de pontage (27, 28) sont essentiellement en forme de plaque et essentiellement exemptes d'isolation électrique par rapport à l'air ambiant, et dans lequel lesdites barres de pontage (27, 28) sont fabriquées en métal, en particulier du cuivre, et sont revêtues de métal, en particulier étamées.

2. Dispositif selon la revendication 1, dans lequel dans une coupe transversale à travers une dite barre de pontage (27, 28), le périmètre de ladite barre de pontage (27, 28) est au moins 20 %, de préférence au moins 30 %, de manière plus préférentielle au moins 40 %, plus grand que le périmètre d'un cercle (C) présentant la même aire que ladite coupe transversale à travers ladite barre de pontage (27, 28).

3. Dispositif selon l'une quelconque des revendications précédentes, dans lequel dans une coupe transversale à travers une dite barre de pontage (27, 28), le diamètre maximal (w) est au moins trois fois plus grand, de préférence au moins cinq fois plus grand, que le diamètre minimal (t).

4. Dispositif selon l'une quelconque des revendications précédentes, dans lequel dans une coupe transversale à travers une dite barre de pontage (27, 28), le diamètre maximal (w) est au moins de 5 mm, de préférence environ de 10 mm.

5. Dispositif selon l'une quelconque des revendications précédentes, dans lequel dans une coupe transversale à travers une dite barre de pontage (27, 28), le diamètre minimal (t) est égal ou inférieur à 1 mm, de préférence environ de 0,5 mm.

6. Dispositif selon l'une quelconque des revendications précédentes, dans lequel lesdites barres de pontage (27, 28) font partie d'une voie de courant fort (19, 20) sur ladite carte de circuit (11).

7. Dispositif selon la revendication 6, dans lequel ladite voie de courant fort (19, 20) peut être connectée à un moteur électrique externe.

8. Dispositif selon la revendication 6 ou 7, dans lequel ladite voie de courant fort (19, 20) peut être connectée à une alimentation électrique externe pour ledit dispositif de consommation de courant électrique.

9. Dispositif selon l'une quelconque des revendications précédentes, dans lequel une dite barre de pontage (27, 28) est dimensionnée pour conduire des courants d'au moins 1 A.
